Europäisches Patentamt

European Patent Office

Office européen des brevets

(19)

(11) Publication number: **0 233 526 B1**

# EUROPEAN PATENT SPECIFICATION

(12)

(45) Date of publication of patent specification: **15.07.92**

(51) Int. Cl.⁵: **G01J 1/44**, H01L 27/14, G03B 3/10

(21) Application number: **87101287.8**

(22) Date of filing: **30.01.87**

(54) **Radiation sensing apparatus.**

(30) Priority: **03.02.86 US 825702**

(43) Date of publication of application:
**26.08.87 Bulletin 87/35**

(45) Publication of the grant of the patent:
**15.07.92 Bulletin 92/29**

(84) Designated Contracting States:
**DE FR GB**

(56) References cited:
**US-A- 4 455 574**
**US-A- 4 484 223**
**US-A- 4 492 980**

**PATENT ABSTRACTS OF JAPAN, vol. 6, no. 176 (E-130)[1054], 10th September 1982; & JP-A-57 92 983**

**PATENT ABSTRACTS OF JAPAN, vol. 6, no. 238 (E-144)[1116], 26th November 1982; & JP-A-57 140 073**

(73) Proprietor: **HONEYWELL INC.**
**Honeywell Plaza**
**Minneapolis MN 55408(US)**

(72) Inventor: **Wilwerding, Dennis J.**
**6840 South Prince Way**
**Littleton Colorado 80120(US)**

(74) Representative: **Herzbach, Dieter et al**
**Honeywell Europe S.A. Holding KG Patent- und Lizenzabteilung Kaiserleistrasse 55**
**Postfach 184**
**W-6050 Offenbach am Main(DE)**

## Description

The present invention relates to a radiation sensing apparatus according to the preamble of claim 1. Such an apparatus is for instance known from US-A-4 492 980 and US-A-4 484 223.

US-A-4 492 980 discloses an image sensing device which includes a light-shielded optical black sensor adapted to provide an output charge produced solely by generation of dark current. This charge is transmitted by a shift register and a switch device to circuitry, which produces a signal to the cells of the solid state device based on the level of dark current charge. These cells generate signal charges in response to light sensed as well as a dark current charge. The signal applied to the cells has the effect of reducing the charge on each such cell by an amount equivalent to the dark current charge. The remaining charge on the cell from which the dark current charge has been subtracted is transmitted by way of the shift register to the output.

US-A-4 484 223 discloses a solid state imaging device having light sensors as well as light-shielded sensors, which are adapted to generate charges corresponding only to dark current charges. Signals from the dark current generating cells are as a first step transmitted by way of a shift register to a charge voltage converting circuit and hence to a latch circuit, the output of which is connected to one terminal of an amplifier. Following transmission of the dark current component, the shift register then transfers charges from the optical sensors. These charges are converted into voltage signals and applied to the second input terminal of the amplifier which then subtracts the dark current component applied to the other input terminal from the signal.

Summarizing it is to note that the firstly cited document implements the dark current compensation within the cell itself on the basis of a charge compensation and the secondly cited document does the same compensation in the field of electrical signals after conversion of the corresponding charges.

Departing from this known devices it is the object of the present invention to devise a radiation sensing apparatus which operates more accurate and has a simpler design. This object is achieved according to the characterizing features of claim 1. Further advantageous embodiments of the inventive apparatus may be taken from the dependent claims.

The signals from the individual detectors are, as shown in the above patents, presented to a shift register in parallel and are fed out of the shift register in series. In actual practice, several of the first shifts from the shift register are "empty bucket" shifts in which there is no information as to the radiation being sensed. The present invention proposes to solve the dark current problem by feeding a compensating signal to the system with one of the empty bucket outputs from the shift register. For example, if the third empty bucket of the shift register were to contain a charge indicative of the dark current in the detectors, then this magnitude signal in the third bucket could be used as a subtracting value for each of the other radiation information containing buckets before they are fed to the sensitive electronics. One way of handling this would be to shield an additional sensor from radiation but expose it to the same other ambient conditions as the other detectors so that it would produce a dark current value which would then be dumped into the third bucket of the shift register. Then when this signal came out of the shift register it would be stored in a sample-and-hold circuit formed by the output circuit floating gate and subtracted from the other signals from the shift register.

FIGURE 1 shows a graph of the output of several detectors as compared with the maximum capabilities of the sensitive electronics in the prior art;

FIGURE 2 shows the same signals of FIGURE 1 but with the dark current subtracted by the present invention;

FIGURE 3 shows a few CCD detectors as arranged with respect to a shift register operable to receive the outputs thereof.

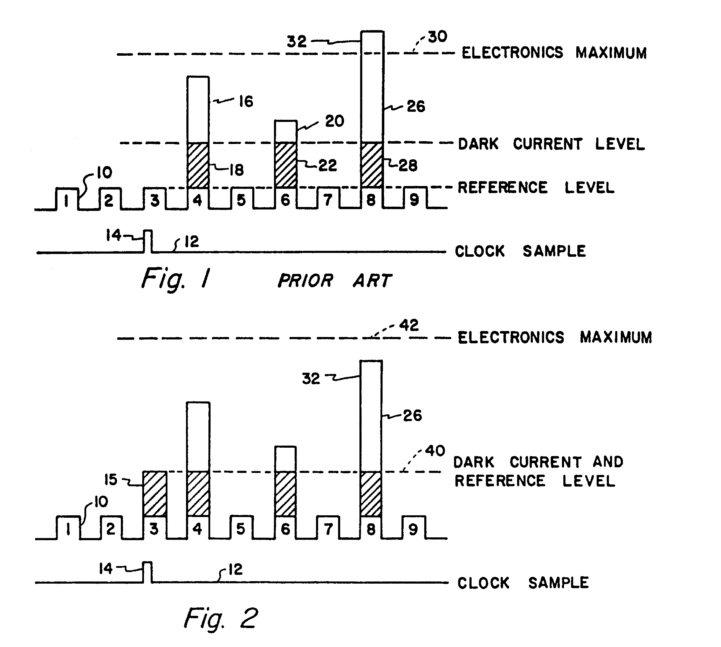

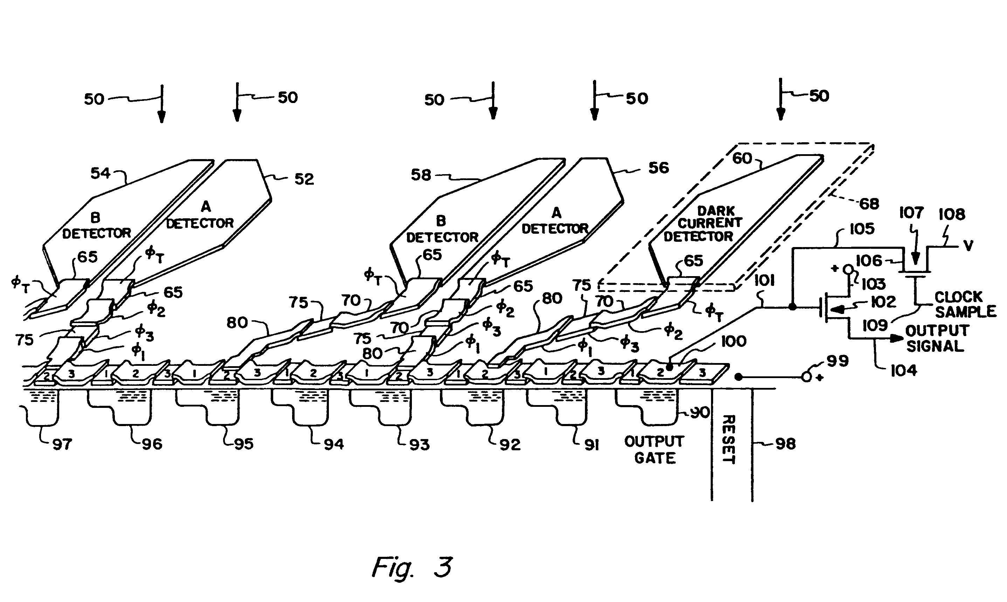

FIGURE 1 is a graph reprsenting the outputs of the first 9 buckets of a CCD shift register as found in the prior art. The square wave 10 represents the contents of the buckets which have been numbered 1-9. As seen, there is a small magnitude of charge in each bucket which is due to the general noise level found in the device. This small signal is identified as the reference level and is generally equal for all of the buckets. Normally this signal is calibrated into the system and produces no particular problem. When a start signal occurs, the charges from the CCD sensors, as will be described in connection with FIGURE 3, dump their accumulated charges into the buckets to which the detectors are connected (in this example the buckets numbered 4, 6 and 8 receive the charge from the first three detectors). The detectors charges are not only representative of the amount of radiation received by each detector but also include a "dark current" charge which is built up on each detector by virtue of the ambient conditions affecting the detector, primarily temperature. While it is customary for the first three buckets to be empty a different number could be used. Furthermore, one of the empty bucket signals may be used to calibrate the output for the small reference level charge. More particularly, in FIGURE 1, a signal identified as the clock sample 12 produces a pulse 14 when it is desired that a reference level signal be taken (at the third bucket in this example). The amount of charge in bucket number three then operates to produce the reference level signal as is commonly done in shift registers.

As the shift register continues to operate, the first detector dumps its signal into bucket 4 as shown by the square pulse 16 and, as seen in FIGURE 1, this includes a hatched portion 18 representative of the dark current level. The next bucket 5 is an empty bucket and the second detector in the line dumps its charge into bucket 6 as shown by square pulse 20. Square pulse 20 also includes a portion 22 representative of the dark current. The next bucket 7 is an empty bucket and the third detector in the line dumps its charge into bucket 8 as shown by square pulse 26 which also includes a hatched portion 28 representative of the dark current. Finally, bucket 9 is again empty. There will of course be a large number of buckets in the chain but only the outputs of three detectors have been shown in FIGURE 1 for simplicity. It is noticed that the bucket 8 in addition to carrying the reference level charge and the dark current charge has a relatively large radiation sensing charge which places the magnitude of the total charge in bucket 8 above the electronics maximum level shown by dash line 30. This results in a clipped signal from bucket 8 that will not include the portion 32 above level 30. As a result, an erroneous representation of the radiation sensed by detector number 3 is given and a possible false focus situation may be produced.

FIGURE 2 shows the situation when the present invention is utilized. Again the square wave 10 is shown representing the charge in buckets 1-9 and again there is a small magnitude of charge due to the noise encountered in the apparatus. Again a clock sample signal 12 having a pulse at 14 is used to produce the reference level signal in the usual way. In FIGURE 2, however, and as will be further explained in connection with FIGURE 3, the charge in bucket 3 includes not only the small noise level signal but also a dark current signal portion 15. This signal is produced by an additional detector placed upstream from the first regular detector but which is shielded from the radiation being sensed. Thus, the only signal in the extra detector is that due to the dark current. Accordingly, the amount of charge in bucket 3 will now contain the dark current signal and this can be used by the circuitry to produce a new reference level shown by dash line 40. The effect of this is to increase the range of the electronics so that now the maximum level shown by dash line 42 is higher than the peak 32 of square pulse 26 since the electronics maximum is the same distance from the reference level as it was in FIGURE 1. It can be seen then that the portion 32 is no longer clipped and the resulting output will not be in error.

Referring now to FIGURE 3, radiation from a scene being viewed passes through a plurality of lenslets (not shown) and is directed thereby to a plurality of detector pairs along lines such as shown by arrows 50. For simplicity, only two pair of detectors are shown in FIGURE 3, the first pair having an A detector 52 and a B detector 54, the second pair having an A detector 56 and a B detector 58 and finally a single detector identified as a dark current detector 60 is shown as a detector having no paired detector associated with it. Although shown to be shaped like the "B" detectors on the left of each pair, the detector 60 can, of course, be shaped like an "A" detector on the right hand side of each pair.

Each of the detectors in FIGURE 3 is shown connected to a first gate 65, all of which are electrically interconnected to a signal source identified as $\Phi T$. When a $\Phi T$ start signal is presented to the system all charge that has been built up on the A and B detectors 52-58 and any dark current charge on detector 60 will be dumped into associated gates 65. It should be noted that the dark current detector 60 has a radiation shield 68 shown in phantom and which prevents light from reaching the dark current detector 60. Accordingly, any charge on this detector will be solely due to the dark current of the system.

Each gate 65 is in turn connected to a gate 70, all of which are electrically connected together to receive a $\Phi 2$ signal. As the $\Phi 2$ signal increases, the $\Phi T$ signal decreases and the charge from the detectors is now dumped from gates 65 into the gates 70. Each gate 70 is connected to a gate 75, all of which are electrically connected together to receive a $\Phi 3$ signal. As the $\Phi 3$ signal increases, the $\Phi 2$ signal will decrease and the detector charge thereon will dump from gates 70 into the gates 75. Each of the gates 75 is connected to a gate 80, all of which are electrically connected to receive a $\Phi 1$ signal. As the $\Phi 1$ signal increases, the $\Phi 3$ signal decreases and all of the charge from the detectors is dumped from gates 75 into the gates 80.

The gates 80 are shown connected in FIGURE 3 to the gates of a line of gates comprising a shift register. In the arrangement shown, gates 80 are connected to associated gates identified by reference numeral 2. Reference numeral 2 indicates that all of the gates bearing this number are connected to receive the $\Phi 2$ signal at the same time for operation to be described below. Each of the shift register gates 2 is shown connected on the right by a shift register gate 3 and on the left by a shift register gate 1 to form a chain of gates. All of the gates bearing reference numeral 1 are electrically connected to receive the Φ1 signal and all of the gates bearing reference numeral 3 are connected together to receive the Φ3 signal for the operation to be described below.

Below each of the gates 1, 2, and 3 are shown a plurality of buckets identified as output 90 and buckets 91-97 progressing to the left. On the far right, after the last gate with reference numeral 3 a reset bucket 98 is shown connected to a source of positive voltage 99. An output gate on the right bearing reference numeral 100 is shown connected by a connection 101 to the gate of a field effect transistor 102 the drain of which is connected to a source of positive voltage 103 and the supply of which is connected to the output signal connection 104. Connection 104 may be connected to sensitive electronics such as an A/D converter (not shown) of an autofocus system. The gate of transistor 102 is joined by a connection 105 to the source 106 of a second field effect transistor 107 having a drain connection 108 connected to a reference voltage V and having a gate 109 connected to a clock sample signal.

In operation, when a start signal ΦT is presented to the system, all of the detectors dump their charge into gates 65 as described above. Then upon the occurrence of a Φ2 signal, the detector signals are dumped into the gates identified by reference numeral 70 as described above. At this time the situation would be as shown in FIGURE 3 with the only charge in the buckets being that which exist under gates with reference numeral 2, i.e. the charge due to the noise of the system and shown by a number of minus signs within the bucket.

In the next step, the signal Φ3 will begin so that the detector charges in gates 70 will begin dumping into gate 75. Likewise at this time, any charges which exist on those gates with reference numeral 2 in the shift register as shown in buckets 91-97 will begin to dump their charge into gates with reference numeral 3. Then as a signal of Φ1 occurs, a signal from the detectors will be dumped into gates 80 and in the shift register, the signals on gates with reference numeral 3 will be dumped into those bearing reference numeral 1. The next step is a second occurrence of a signal Φ2 which will move the charge from gates 80 into the gates 2 of the shift register. By this time bucket number 90 will have dumped into the reset bucket 98, bucket 91 will be moved over to a position under the output gate 100 and its charge will be passed along connection 101 to field effect transistor 102 and produce an output signal on line 104. Bucket 92 will be moved to the right so that it occupies the position shown now by bucket 91 and the same will be true for all of the buckets shown in FIGURE 3.

Accordingly, the dark current charge which exists on gate 80 connected to dark current detector 60 will be dumped into bucket 93, the charge from the "A" detector 56 will be dumped into bucket 94, the charge on the "B" detector 58 will be dumped into bucket 96, the charge on A detector 52 will be dumped into a bucket which is immediately to the left of bucket 97 (not shown) and similarly with the charge on the "B" detector 54.

Upon the next occurrence of a Φ3 signal, the dark current charge in bucket 93 will be moved to the right, the charge from detector 56 in bucket 94 will be moved to the right, etc., and, as is well known in the shift register art, the charges will be progressively moved to the right as successive signals of phase 1, 2, and 3 occur. The result is that the signals from the dark current detector 60 and from the radiation detectors 52-56 will be serially presented to the field effect transistor 102 and thus to the output 108.

The voltage on connection 101 and output signal connection 104 is determined by the charge on line 101 as well as the charge under the shift register output gate 100. Thus, the signal including dark current and background charge is converted to a voltage signal at this point. Since the charge on line 101 effects the voltage on connection 101 and the output signal on connection 104, the starting or A/D reference voltage on connection 104 may be set by precharging connection 101 to a predetermined voltage. This effectively offsets the output signal on connection 104 to the desired A/D reference level. In the prior art, this reseting of the output circuit was accomplished at a clock cycle as shown in FIGURE 1. By changing the CCD structure to cause a signal proportional to the average dark current to be in the output bucket 90 of the shift register at the time the output gate voltage is preset, the circuit effectively offsets all signals by an amount proportional to the dark current.

The gate of output transistor 102 connected to line 101 is preset to the A/D reference voltage by causing the second transistor 107 to become conductive. This occurs in response to a clock sample signal on connection 109 which is the same as the clock sample signal shown in FIGURES 1 and 2. When transistor 107 is conductive, connection 101 is connected to the reference V on connection 108, a DC voltage of proper value to cause the output signal on connection 104 to be at the desired A/D converter reference voltage level. At other times, when there is no clock sample pulse on connection 109, transistor 107 is non-conductive and connection 101 is floating and responsive to any changes in the charge level of the output bucket 90 of the shift register.

Thus, the input to the A/D converter will be devoid of the undesireable dark current signal thus alowing greater accuracy and less change of clipping than the prior art circuit.

## Claims

1. Radiation sensing apparatus comprising:
   a plurality of radiation sensing detectors (52-56) which transfer radiation indicative charge signals to a plurality of receiving buckets (93-97) of a shift register, said shift register transmitting the charge signals in series to an output gate, and
   a dark current sensing detector (60) being connected to one (92) of a plurality of empty buckets (90-92) of said shift register, the empty buckets being positioned in front of said receiving buckets,
   **characterized by**
   receiving means (100-109) operable to receive an output charge signal when emerging from the empty bucket (90) being positioned under the output gate of the shift register and to subtract it from the charge signals in the receiving buckets (93-97) at the time when emerging from the empty bucket (90) being positioned under the output gate of the shift register before those charge signals are converted into voltage signals.

2. Apparatus according to claim 1, **characterized in that** one empty bucket (92) adjacent to said receiving buckets (93-97) is connected to said dark current sensing detector (60).

3. Apparatus according to claim 2, with said receiving means comprising first and second field effect transistors (102,107) connected to receive the output signal charges of said shift register, **characterized by** means (109) for connecting the gate of said second field effect transistor (107) to receive a clock signal when said empty bucket (90) being positioned under the output gate within said shift register contains a charge signal according to the dark current.

## Revendications

1. Dispositif de détection de rayonnement comprenant :
   plusieurs détecteurs (52, 56) captant un rayonnement qui transfèrent des signaux de charge indicatifs de rayonnement à plusieurs godets récepteurs (93-97) d'un registre à décalage, ledit registre à décalage transmettant les signaux de charge en série à une porte de sortie, et
   un détecteur (60) captant un courant sombre qui est relié à l'un (92) parmi plusieurs godets vides (90, 92) dudit registre à décalage, les godets vides étant positionnés en face desdits godets récepteurs,
   **caractérisé en ce que**
   des moyens récepteurs (100-109) pouvant fonctionner pour recevoir un signal de charge de sortie lorsqu'il émerge du godet vide (90) étant positionnés au-dessous de la porte de sortie du registre à décalage et pouvant le le soustraire des signaux de charge des godets récepteurs (93-97) lorsqu'il émerge du godet vide (90) étant positionnés au-dessous de la porte de sortie du registre à décalage avant que ces signaux de charge ne soient convertis en signaux de tension.

2. Dispositif selon la revendication 1, **caractérisé en ce** qu'un godet vide (92) adjacent auxdits godets récepteurs (93-97) est relié audit détecteur (60) capteur de courant sombre.

3. Dispositif selon la revendication 2, lesdits moyens récepteurs comprenant un premier et un deuxième transistors à effet de champ (102, 107) reliés pour recevoir les charges de signal de sortie dudit registre à décalage, **caractérisé par** des moyens (109) pour relier la grille dudit deuxième transistor à effet de champ (107) afin de recevoir un signal d'horloge lorsque ledit godet vide (90) qui est positionné au-dessous de la grille de sortie à l'intérieur dudit registre à décalage contient un signal de charge conforme au courant sombre.

## Patentansprüche

1. Strahlungsmeßvorrichtung aufweisend:
   mehrere Strahlung erfassende Sensoren (52-56), welche die Strahlung anzeigende Ladungssignale zu mehreren Empfangszellen (93-97) eines Schieberegisters übertragen und wobei das Schieberegister die Ladungssignale der Reihe nach zu einem Ausgangsgatter überträgt, und
   ein den Dunkelstrom erfassender Detektor (60), der an eine von mehreren leeren Zellen (90-92) des Schieberegisters angeschlossen ist, wobei die leeren Zellen vor den Empfangszellen angeordnet sind,
   **gekennzeichnet durch**
   eine Empfangseinrichtung (100-109), der ein Ausgangs-Ladungssignal zugeführt wird, wenn dieses aus der leeren Zelle (90) unter dem Ausgangsgatter des Schieberegisters austritt und die dieses von dem Ladungssignal in den Empfangszellen (93-97) zu dem Zeitpunkt subtrahiert, wenn es aus der leeren Zelle (90) unter dem Ausgangsgatter des Schieberegisters austritt und bevor diese Ladungssignale in Spannungssignale umgewandelt werden.

2.  Vorrichtung nach Anspruch 1, **dadurch gekennzeichnet,** daß eine leere Zelle (92) benachbart zu den Empfangszellen (93-97) an den den Dunkelstrom erfassenden Detektor (60) angeschlossen ist.

3.  Vorrichtung nach Anspruch 2, wobei die Empfangseinrichtung erste und zweite Feldeffekttransistoren (102,107) aufweist, denen die Ausgangs-Ladungssignale des Schieberegisters zugeführt werden, **gekennzeichnet durch**
    Mittel (109) zum Anschluß des Gatters des zweiten Feldeffekttransistors (107) an ein Taktsignal, wenn die leere Zelle (90), die unter dem Ausgangsgatter des Schieberegisters angeordnet ist, ein Ladungssignal gemäß dem Dunkelstrom enthält.

Fig. 1    PRIOR ART

Fig. 2

Fig. 3

EP 0 233 526 B1